# EUROPEAN PATENT SPECIFICATION

(11) **EP 4 357 065 B1**
(45) Date of publication and mention of the grant of the patent: **28.10.2026**
(21) Application number: 22824619.5
(22) Date of filing: 29.03.2022
(51) Int. Cl.: B23K 26/364, B23K 26/0622, B23K 26/40, B23K 26/53, C30B 29/06, C30B 33/06, B23K 26/402

(54) **METHOD FOR DIVIDING COMPOSITE MATERIAL**
VERFAHREN ZUM TEILEN VON VERBUNDMATERIAL
PROCÉDÉ DE DIVISION DE MATÉRIAU COMPOSITE

(30) Priority: 14.06.2021 JP 2021098404
(43) Date of publication of application: 24.04.2024
(73) Proprietor: Nitto Denko Corporation, Ibaraki-shi, Osaka 567-8680 (JP)
(72) Inventor: HIRATA, Satoshi, Ibaraki-shi, Osaka 567-8680 (JP); KANNO, Toshihiro, Ibaraki-shi, Osaka 567-8680 (JP); YANO, Takanobu, Ibaraki-shi, Osaka 567-8680 (JP)
(74) Representative: Hoffmann Eitle
(86) International application number: PCT/JP2022/015409
(87) International publication number: WO 2022/264623

(56) References cited:
- WO-A1-2021/009961
- WO-A1-2022/049824
- JP-A- 2009 280 447
- JP-A- 2010 201 479
- JP-A- 2016 166 120
- JP-A- 2019 122 966
- JP-A- H10 506 087

## Description

The present invention relates to a method for dividing a composite material in which a brittle material layer and a resin layer are laminated, see claim 1. The present invention particularly relates to a method that is less likely to cause cracks on the end surface of a brittle material layer after division, and that allows a composite material (a composite material piece) to have sufficient bending strength after division.

### [Background Art]

In image display devices used for televisions or personal computers, a protective material is often disposed on the outermost surface of the image display device to protect the image display device. A glass plate is typically used as the protective material.

As in the case of image display devices used for smartphones, smart watches, on-vehicle displays, or the like, there is an increasing demand for a thin protective material having both a protection function and an optical function due to reduction in size, thickness, and weight of image display devices. Examples of such a protective material include a composite material in which a brittle material layer and a resin layer are laminated, the brittle material layer having a protection function and being made of glass or the like, the resin layer having an optical function and being made from a polarizing film. It is necessary to divide this composite material into a predetermined shape and predetermined dimensions depending on the application.

Conventionally, a method described in Patent Literature 1 has been proposed as a method for dividing a composite material in which a brittle material layer and a resin layer are laminated.

The method described in Patent Literature 1 includes a resin removing step and a brittle material removing step, and a processed mark is a through hole that penetrates through a brittle material layer, a resin layer being irradiated with a laser beam, which is oscillated from a laser light source, such as a CO₂ laser light source, along a scheduled dividing line of a composite material to remove a resin forming the resin layer, thus forming a processed groove along the scheduled dividing line in the resin removing step, the brittle material removing step being performed after the resin removing step, the brittle material layer being irradiated with a laser beam, which is oscillated from an ultrashort pulse laser light source, along the scheduled dividing line to remove a brittle material forming the brittle material layer, thus forming a processed mark along the scheduled dividing line in the brittle material removing step.

According to the method described in Patent Literature 1, the brittle material forming the brittle material layer is removed by using the laser beam oscillated from the ultrashort pulse laser light source and hence, it is possible to obtain an advantage that cracks are less likely to occur on the end surface of the brittle material layer after division.

Also with the method described in Patent Literature 1, it is possible to allow the composite material to have a predetermined bending strength after division. However, there is a demand for having a more sufficient bending strength.

Non Patent Literature 1 describes that, in a processing technique that uses an ultrashort pulse laser beam, the filamentation phenomenon of the ultrashort pulse laser beam is used, and a multi-focus optical system or a Bessel beam optical system is used as an ultrashort pulse laser light source.

Non Patent Literature 2 describes a two-point bending stress of a thin glass substrate.

### [Citation List]

### [Patent Literature]

[Patent Literature 1] JP2019-122966A

### [Non Patent Literature]

[Non Patent Literature 1] John Lopez et al., "GLASS CUTTING USING ULTRASHORT PULSED BESSEL BEAMS", [online], 2015, October, International Congress on Applications of Lasers & Electro-Optics (ICALEO), [searched on July 17, 2020], the Internet (URL:https://www.researchgate.net/publication/284617626_GLASS_CUT TING_USING_ULTRASHORT_PULSED_BESSEL_BEAMS)
[Non Patent Literature 2] Suresh T. Gulati et al., "Two Point Bending of Thin Glass Substrate", 2011, SID 11 DIGEST, p.652 to 654

Further related art may be found in WO 2022/049824 A1, which is an intermediate document according to Article 54 (3) EPC, and describes a method for dividing a composite material and a composite material and in WO 2021/009961 A1 (describing the preamble of claim 1), which shows a method for dividing a composite material.

### [Summary of Invention]

### [Technical Problem]

An object of the present invention, which has been made to solve the above-mentioned problem of the conventional technique, is to provide a method that is less likely to cause cracks on the end surface of a brittle material layer after division, and that allows a composite material (composite material piece) to have sufficient bending strength after division.

### [Solution to Problem]

To solve the above-mentioned problem, the inventors of the present invention have conducted extensive studies and, as a result, found the following. By setting the focal point of a laser beam to a position, in a resin layer, which is located in the vicinity of an interface with a brittle material layer, in a state in which the thickness of the resin layer at an irradiation position that is irradiated with the laser beam to be oscillated from an ultrashort pulse laser light source is a predetermined value or more (5 µm or more), and by performing irradiation from the brittle material layer side with the laser beam along a scheduled dividing line, a brittle material only on the resin layer side of the brittle material layer is removed, thus forming a scribe groove integrally connected along the scheduled dividing line. The inventors of the present invention also found that a composite material is divided by using this scribe groove as a starting point and hence, cracks are less likely to occur on the end surface of the brittle material layer after division, and the composite material is allowed to have sufficient bending strength after division.

The present invention is completed based on the above-mentioned findings of the inventors of the present invention. The present invention is defined by the appended independent claim 1. The dependent claims describe optional features and distinct embodiments.

That is, to solve the above-mentioned problem, the present invention provides a method for dividing a composite material in which a brittle material layer and a resin layer are laminated, the method comprising: a brittle material removing step in which irradiation is performed from a brittle material layer side with a laser beam, which is oscillated from an ultrashort pulse laser light source, along a scheduled dividing line of the composite material to remove a brittle material forming the brittle material layer, thus forming a scribe groove integrally connected along the scheduled dividing line; and a resin removing step in which the resin layer is irradiated with a laser beam, which is oscillated from a laser light source, along the scheduled dividing line to remove a resin forming the resin layer, wherein in the brittle material removing step, the laser beam is oscillated from the ultrashort pulse laser light source to form the scribe groove that is open on a resin layer side, but is prevented from penetrating through the brittle material layer, the laser beam being oscillated in a state in which a focal point of the laser beam to be oscillated from the ultrashort pulse laser light source is set to a position, in the resin layer, which is located in a vicinity of an interface with the brittle material layer, and a thickness of the resin layer at an irradiation position that is irradiated with the laser beam to be oscillated from the ultrashort pulse laser light source is 5 µm or more.

According to the method for dividing a composite material according to the present invention, in the brittle material removing step, irradiation is performed with the laser beam, which is oscillated from the ultrashort pulse laser light source, to remove the brittle material forming the brittle material layer, thus forming the scribe groove on the brittle material layer. Accordingly, the composite material is divided by using this scribe groove as a starting point and hence, cracks are less likely to occur on the end surface (the end surface in the direction orthogonal to the thickness direction of the composite material (the direction in which the brittle material layer and the resin layer are laminated)) of the brittle material layer after division.

Further, according to the method for dividing a composite material according to the present invention, the scribe groove formed in the brittle material removing step is open on the resin layer side, but is prevented from penetrating through the brittle material layer. In other words, in the brittle material removing step, a brittle material only on the resin layer side of the brittle material layer is removed to form the scribe groove. Accordingly, the composite material is divided by using this scribe groove as a starting point and hence, as the inventors of the present invention found, it is possible to allow the composite material to have sufficient bending strength after division.

Although the mechanism of forming the scribe groove by the present invention is not necessarily clear, the inventors of the present invention have presumed that, by setting the focal point of a laser beam to a position, in the resin layer, which is located in the vicinity of the interface with the brittle material layer, energy of the laser beam is absorbed in a concentrated manner at the position, in the resin layer, which is located in the vicinity of the interface with the brittle material layer and hence, heat is generated and is conducted to the brittle material layer, so that a brittle material at the position at which the heat is conducted is removed, thus forming the scribe groove.

In the method for dividing a composite material according to the present invention, the statement "perform irradiation from the brittle material layer side with a laser beam along the scheduled dividing line of the composite material" means to irradiate the composite material with a laser beam along the scheduled dividing line from the brittle material layer side as viewed in the thickness direction of the composite material (the direction in which the brittle material layer and the resin layer are laminated). In the method for dividing a composite material according to the present invention, the statement "irradiate the resin layer with a laser beam along the scheduled dividing line" means to irradiate the resin layer with a laser beam along the scheduled dividing line as viewed in the thickness direction of the composite material.

In the method for dividing a composite material according to the present invention, the statement "a position, in the resin layer, which is located in the vicinity of the interface with the brittle material layer" means the interface itself between the resin layer and the brittle material layer and a region of the resin layer that is close to the interface (for example, a region distant from the interface at a distance of 20 µm or less, preferably at a distance of 10 µm or less, in the thickness direction of the composite material). The statement "set the focal point of the laser beam to be oscillated from the ultrashort pulse laser light source to a position, in the resin layer, which is located in the vicinity of the interface with the brittle material layer" means to set the position of the focal point of a laser beam in the thickness direction of the composite material to a position, in the resin layer, which is located in the vicinity of the interface with the brittle material layer.

Further, in the method for dividing a composite material according to the present invention, the kind of laser light source used in the resin removing step is not particularly limited provided that the resin forming the resin layer can be removed by the laser beam oscillated from the laser light source. However, from the perspective of being capable of increasing the relative moving speed (processing speed) of the laser beam with respect to the composite material, it is preferable to use a CO₂ laser light source or a CO laser light source that oscillates a laser beam with a wavelength within the infrared range.

In the method for dividing a composite material according to the present invention, the brittle material removing step may be performed after the resin removing step is performed previously. However, in this case, a resin cannot be completely removed along the scheduled dividing line in the resin removing step, and it is necessary to intentionally leave the resin by an amount corresponding to a thickness of 5 µm or more. A residual amount of the resin may change depending on power of a laser beam to be oscillated from the laser light source in the resin removing step and a relative moving speed (processing speed) of the laser beam with respect to the composite material, for example, and hence, effort is required in adjusting the residual amount of the resin. Further, when an excessively large amount of resin is left, there is a possibility of problems occurring in the division of the composite material.

Therefore, in the method for dividing a composite material according to the present invention, it is preferable that the resin removing step is performed after the brittle material removing step.

According to the above-mentioned preferred method, the scribe groove is formed in the brittle material removing step which is performed previously and hence, no problems occur even when a resin is completely removed along the scheduled dividing line in the resin removing step which is performed after the scribe groove is formed. Therefore, it is possible to avoid a possibility of requiring effort in adjusting power or the like of the laser beam, and a possibility of problems occurring in the division of the composite material.

Preferably, the method for dividing a composite material according to the present invention further comprising a composite material dividing step in which the composite material is divided by applying an external force along the scheduled dividing line, the composite material dividing step being performed after the brittle material removing step and the resin removing step are performed.

According to the above-mentioned preferred method, it is possible to surely divide the composite material.

According to the findings of the inventors of the present invention, a smaller depth of the scribe groove allows the composite material to have more sufficient bending strength after division. However, an excessively small depth of the scribe groove causes problems in the division of the composite material.

Therefore, in the method for dividing a composite material according to the present invention, it is preferable that a depth of the scribe groove is within a range of 3 µm or more and 50 µm or less. The lower limit is more preferably set to 5 µm or more, and is further preferably set to 10 µm or more. The upper limit is more preferably set to 30 µm or less, is still more preferably set to 20 µm or less, is further preferably set to 18 µm or less, and is still further preferably set to 16 µm or less.

In the above-mentioned preferred method, the statement "the depth of the scribe groove" means a distance between the end of the scribe groove on the resin layer side (the opening end of the scribe groove) and the bottom portion of the scribe groove on the brittle material layer side (the end of the scribe groove on the side opposite to the opening end). Further, in the above-mentioned preferred method, the statement "the depth of the scribe groove is within a range of 3 µm or more and 50 µm or less" means that the average value of the depths of the scribe groove along the scheduled dividing line is within a range of 3 µm or more and 50 µm or less.

In the method for dividing a composite material according to the present invention, it is preferable that a depth of the scribe groove is within a range of 10% or more and 50% or less of a thickness of the brittle material layer. The lower limit is more preferably set to 15% or more. The upper limit is more preferably set to 35% or less.

In the method for dividing a composite material according to the present invention, it is preferable that a wavelength of the laser beam to be oscillated from the ultrashort pulse laser light source is within a range of 500 nm or more and 2500 nm or less.

In the method for dividing a composite material according to the present invention, a pulse width of the laser beam to be oscillated from the ultrashort pulse laser light source is, for example, within a range of 350 femtoseconds or more and 10000 femtoseconds or less.

### [Advantageous Effects of Invention]

According to the present invention, cracks are less likely to occur on the end surface of the brittle material layer after division, and it is possible to allow the composite material to have sufficient bending strength after division.

### [Brief Description of Drawings]

[Figure 1] Figures 1(a) to 1(c) (collectively referred to as Figure 1) are explanatory views schematically describing the procedure for a method for dividing a composite material according to one embodiment of the present invention.
[Figure 2] Figures 2(a) and 2(b) (collectively referred to as Figure 2) are explanatory views schematically describing the procedure for the method for dividing a composite material according to one embodiment of the present invention.
[Figure 3] Figure 3 is an explanatory view schematically describing one example of a method for setting a focal point of a laser beam to be oscillated from an ultrashort pulse laser light source shown in Figure 1A.
[Figure 4] Figure 4 is a cross-sectional view schematically showing the configuration of a composite material piece obtained after the composite material is divided in a composite material dividing step of the division method according to one embodiment of the present invention.
[Figure 5] Figures 5(a) to 5(c) (collectively referred to as Figure 5) are diagrams schematically describing a summary of a test according to an example 1.
[Figure 6] Figure 6 is diagram showing results of tests according to examples 1, 2 and comparison examples 1, 2.

### [Description of Embodiment]

Hereinafter, a method for dividing a composite material (hereinafter, simply referred to as "division method" when appropriate) according to one embodiment of the present invention will be described by suitably referring to attached drawings.

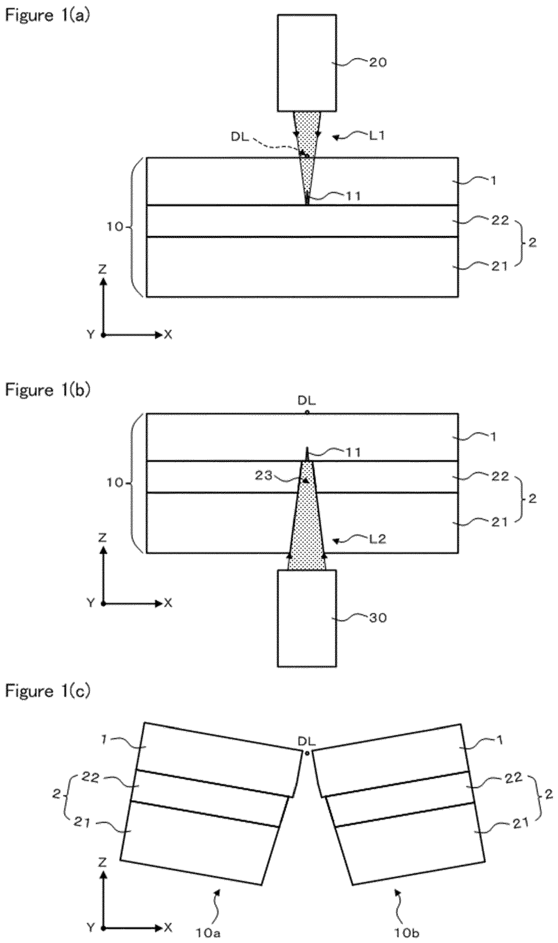

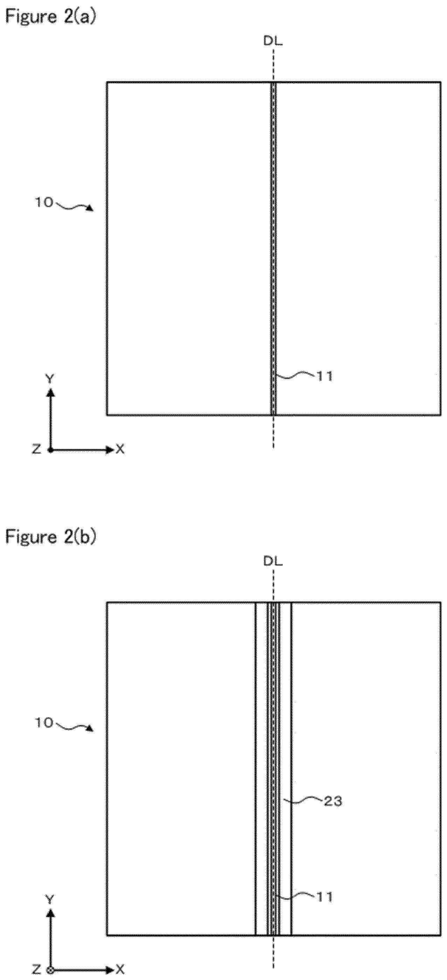

Figure 1 and Figure 2 are explanatory views schematically describing the procedure for the method for dividing a composite material according to one embodiment of the present invention. Figure 1(a) is a cross-sectional view showing a brittle material removing step of the division method according to the present embodiment, Figure 1(b) is a cross-sectional view showing a resin removing step of the division method according to the present embodiment, and Figure 1(c) is a cross-sectional view showing a composite material dividing step of the division method according to the present embodiment. Figure 2(a) is a top plan view showing a composite material after the brittle material removing step of the division method according to the present embodiment (a plan view as viewed from a brittle material layer side), and Figure 2(b) is a bottom plan view showing the composite material after the resin removing step of the division method according to the present embodiment (a plan view as viewed from a resin layer side).

The division method according to the present embodiment is a method for dividing a composite material 10, in which a brittle material layer 1 and a resin layer 2 are laminated, along the thickness direction (the direction in which the brittle material layer 1 and the resin layer 2 are laminated, the up and down direction or the Z direction in Figure 1).

The brittle material layer 1 and the resin layer 2 are laminated by any suitable method. For example, the brittle material layer 1 and the resin layer 2 may be laminated by a so-called roll-to-roll method. That is, by bonding a long brittle material layer 1 and a long resin layer 2 together with the longitudinal direction of the brittle material layer 1 and the longitudinal direction of the resin layer 2 aligned with each other while the brittle material layer 1 and the resin layer 2 are conveyed in the longitudinal direction, the brittle material layer 1 and the resin layer 2 can be laminated. It is also possible to adopt a configuration in which the brittle material layer 1 and the resin layer 2 are cut into a predetermined shape and, thereafter, are laminated. The brittle material layer 1 and the resin layer 2 are typically laminated via any suitable pressure-sensitive adhesive or adhesive agent.

Examples of the brittle material forming the brittle material layer 1 include glass and single crystal or polycrystalline silicon.

According to the classification based on a composition, examples of glass include soda-lime glass, borate glass, aluminosilicate glass, quartz glass, and sapphire glass. According to the classification based on an alkali component, examples of glass include alkali-free glass and low alkaline glass. A content of alkali metal component (Na₂O, K₂O, Li₂O, for example) of glass is preferably set to 15 weight% or less, and is more preferably set to 10 weight% or less.

The thickness of the brittle material layer 1 is preferably set to 200 µm or less, is more preferably set to 150 µm or less, is further preferably set to 120 µm or less, and is particularly preferably set to 100 µm or less. Further, the thickness of the brittle material layer 1 is preferably set to 5 µm or more, is more preferably set to 20 µm or more, and is further preferably set to 30 µm or more. The brittle material layer 1 having a thickness which falls within such a range can be laminated to the resin layer 2 by the roll-to-roll method.

In the case in which a brittle material forming the brittle material layer 1 is glass, light transmittance of the brittle material layer 1 at the wavelength of 550 nm is preferably set to 85% or more. In the case in which the brittle material forming the brittle material layer 1 is glass, the refractive index of the brittle material layer 1 at the wavelength of 550 nm is preferably set to 1.4 to 1.65. In the case in which the brittle material forming the brittle material layer 1 is glass, density of the brittle material layer 1 is preferably set to within a range of 2.3 g/cm³ to 3.0 g/cm³, and more preferably set to within a range of 2.3 g/cm³ to 2.7 g/cm³.

In the case in which the brittle material forming the brittle material layer 1 is glass, for the brittle material layer 1, a commercially available glass plate may be used as it is, or a commercially available glass plate may be used after being ground to have a desired thickness. Examples of the commercially available glass plate include "7059", "1737", and "EAGLE2000" made by Corning Incorporated, "AN100" made by Asahi Glass Co., Ltd., "NA-35" made by NH Techno Glass Corporation, "OA-10" made by Nippon Electric Glass Co., Ltd., and "D263" and "AF45" made by Schott AG.

Examples of the resin layer 2 include a monolayer film made of, and a laminated film formed of a plurality of layers of polyethylene terephthalate (PET), polyethylene (PE), polypropylene (PP), an acrylic resin, such as polymethylmethacrylate (PMMA), cyclic olefin polymer (COP), cyclic olefin copolymer (COC), polycarbonate (PC), a urethane resin, polyvinyl alcohol (PVA), polyimide (PI), polytetrafluoroethylene (PTFE), polyvinyl chloride (PVC), polystyrene (PS), triacetyl cellulose (TAC), polyethylene naphthalate (PEN), ethylene-vinyl acetate (EVA), polyamide (PA), a silicone resin, an epoxy resin, liquid crystal polymer, or a plastic material, such as any of various resin foams.

In the case in which the resin layer 2 is a laminated film formed of a plurality of layers, any of various pressure-sensitive adhesives, such as an acrylic pressure-sensitive adhesive, a urethane-based pressure-sensitive adhesive, or a silicone-based pressure-sensitive adhesive, or any of various adhesive agents, such as an epoxy adhesive agent, may be interposed between layers. A pressure-sensitive adhesive layer or an adhesive agent layer made of the above-mentioned pressure-sensitive adhesive or adhesive agent may be formed on the surface of the resin layer 2.

A conductive inorganic film made of indium tin oxide (ITO), Ag, Au, Cu may be formed on the surface of the resin layer 2.

The division method according to the present embodiment is particularly preferably used in the case in which the resin layer 2 is any of various optical films used for a display, such as a polarizing film, a surface protective film, or a phase difference film.

The thickness of the resin layer 2 is preferably set to 20 to 500 µm.

Figure 1 illustrates the example in which the resin layer 2 is a surface protective film formed of a base film 21, made of PET, and a pressure-sensitive adhesive layer 22, formed on one surface of the base film 21, and the composite material 10 is configured such that the brittle material layer 1 and the resin layer 2 are laminated via the pressure-sensitive adhesive layer 22.

The division method according to the present embodiment includes the brittle material removing step, the resin removing step, and the composite material dividing step. Hereinafter, respective steps are described in order.

### <Brittle material removing step>

As shown in Figure 1(a) and Figure 2(a), in the brittle material removing step, irradiation is performed from the brittle material layer 1 side with a laser beam (ultrashort pulse laser beam) L1, which is oscillated (pulse oscillated) from an ultrashort pulse laser light source 20, along a scheduled dividing line of the composite material 10 to remove a brittle material forming the brittle material layer 1, thus forming a scribe groove 11 integrally connected along the scheduled dividing line.

In the example shown in Figure 1 and Figure 2, the case is illustrated in which, of two directions (the X direction and the Y direction) orthogonal to each other in plane (XY two-dimensional plane) of the composite material 10, a straight line DL extending in the Y direction is the scheduled dividing line. The scheduled dividing line DL may be actually drawn on the composite material 10 as an indication that can be visually perceived, or the coordinates of the scheduled dividing line DL may be inputted in advance in a control device (not shown in the drawing) that controls the relative positional relationship between the laser beam L1 and the composite material 10 on the XY two-dimensional plane. The scheduled dividing line DL shown in Figure 1 and Figure 2 is an imaginary line that is not actually drawn on the composite material 10, and the coordinates of the scheduled dividing line DL are inputted in advance in the control device. The scheduled dividing line DL is not limited to a straight line, and may be a curved line. By determining the scheduled dividing line DL depending on the application of the composite material 10, it is possible to divide the composite material 10 into any shape depending on the application.

For a mode of performing irradiation with the laser beam L1 along the scheduled dividing line DL of the composite material 10 (a mode of performing scanning with the laser beam L1), the following mode can be considered, for example. A sheet-like composite material 10 is placed on and fixed (adhered and fixed, for example) to an XY two-axis stage (not shown in the drawing), and the XY two-axis stage is driven in response to a control signal from the control device to change the relative position of the composite material 10 with respect to the laser beam L1 on the XY two-dimensional plane. The following mode can also be considered. The position of the composite material 10 is fixed, and a laser beam L1 oscillated from the ultrashort pulse laser light source 20 is deflected by using a galvanomirror or a polygon mirror, which is driven in response to a control signal from the control device, to change the position, on the XY two-dimensional plane, of the laser beam L1 with which the composite material 10 is irradiated. It is also possible to adopt both the above-mentioned scanning of the composite material 10 performed by using the XY two-axis stage and the above-mentioned scanning performed with the laser beam L1 by using a galvanomirror or the like.

The brittle material forming the brittle material layer 1 is removed by making use of the filamentation phenomenon of the laser beam L1 oscillated from the ultrashort pulse laser light source 20, or by using a multi-focus optical system (not shown in the drawing) or a Bessel beam optical system (not shown in the drawing) as the ultrashort pulse laser light source 20.

The technique of making use of the filamentation phenomenon of an ultrashort pulse laser beam and the technique of using a multi-focus optical system or a Bessel beam optical system as an ultrashort pulse laser light source are described in Non Patent Literature 1 described above. Further, TRUMPF SE + Co. KG., which is a German company, sells a product related to glass processing in which a multi-focus optical system is used as an ultrashort pulse laser light source. As described above, the technique of making use of the filamentation phenomenon of an ultrashort pulse laser beam and the technique of using a multi-focus optical system or a Bessel beam optical system as an ultrashort pulse laser light source are known techniques and hence, the further detailed description of such techniques will be omitted in the present embodiment.

The wavelength of the laser beam L1 to be oscillated from the ultrashort pulse laser light source 20 is preferably set to within a range of 500 nm or more and 2500 nm or less, which allows high light transmittance in the case of the brittle material forming the brittle material layer 1 is glass. To effectively cause a nonlinear optical phenomenon (multiphoton absorption), the pulse width of the laser beam L1 is preferably set to 100 picoseconds or less, and is more preferably set to 50 picoseconds or less. The pulse width of the laser beam L1 is set to within a range of 350 femtoseconds or more and 10000 femtoseconds or less, for example. The oscillation mode of the laser beam L1 may be single-pulse oscillation or multi-pulse oscillation in a burst mode.

In the brittle material removing step, the focal point of the laser beam L1 to be oscillated from the ultrashort pulse laser light source 20 is set to a position, in the resin layer 2, which is located in the vicinity of the interface with the brittle material layer 1. Therefore, the scribe groove 11 formed in the brittle material removing step is open on the resin layer 2 side, but is prevented from penetrating through the brittle material layer 1 (not open on the side opposite to the resin layer 2 side). In other words, in the brittle material removing step, a brittle material only on the resin layer 2 side of the brittle material layer 1 is removed to form the scribe groove 11.

Hereinafter, such a point will be described more specifically.

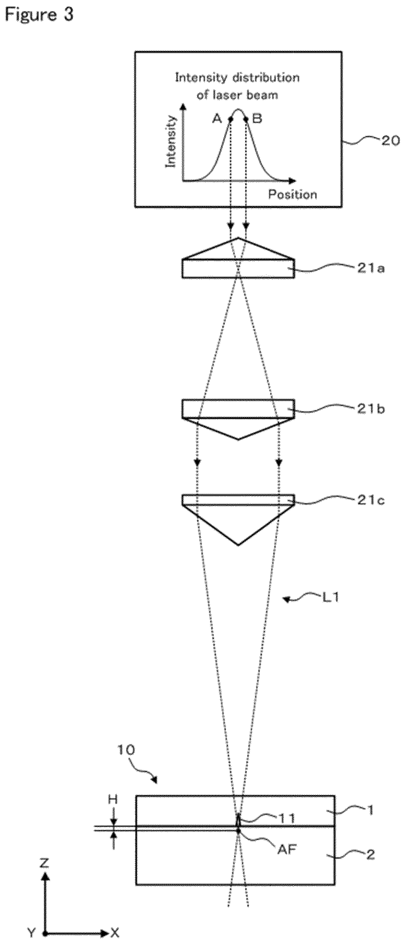

Figure 3 is an explanatory view schematically describing one example of a method for setting the focal point of the laser beam L1 to be oscillated from the ultrashort pulse laser light source 20.

In the example shown in Figure 3, a multi-focus optical system is used as the ultrashort pulse laser light source 20. Specifically, the multi-focus optical system shown in Figure 3 is formed of three axicon lenses 21a, 21b, 21c. Assuming that, as shown in Figure 3, spatial intensity distribution of the laser beam L1 to be oscillated from the ultrashort pulse laser light source 20 is Gaussian distribution, the laser beam L1 oscillated within a range from a point A to a point B, having relatively high intensity, passes through the optical path shown by dashed lines in Figure 3, and is focused at a focal point AF. In the brittle material removing step of the present embodiment, the focal point set to a position, in the resin layer 2, which is located in the vicinity of the interface with the brittle material layer 1 is the focal point AF at which the laser beam L1 oscillated within a range of relatively high intensity, that is, a range from the point A to the point B, is focused. The range from the point A to the point B is, for example, a range having intensity of 90% or more of the maximum intensity in the spatial intensity distribution of the laser beam L1.

In the brittle material removing step, the positional relationship between the focal point AF and the composite material 10 is adjusted such that the position of the focal point AF of the laser beam L1 is set to a position, in the resin layer 2, which is located in the vicinity of the interface with the brittle material layer 1, specifically, is set to the position distant from the interface at a distance H. The distance H is preferably set to within a range of 0 µm to 20 µm, and is more preferably set to within a range of 0 µm to 10 µm.

The spot diameter of the laser beam L1 at the focal point AF is preferably set to 5 µm or less, and is more preferably set to 3 µm or less.

In the case of making use of the filamentation phenomenon of the laser beam L1, when the laser beam L1 transmits through the brittle material layer 1, self-focusing is caused by the Kerr effect and hence, the spot diameter decreases as the laser beam L1 advances. When the laser beam L1 is focused to an energy threshold at which ablation is generated in the brittle material layer 1, the brittle material of the brittle material layer 1 is removed, so that the scribe groove 11 is formed. By setting the position, at which the laser beam L1 is focused to the energy threshold at which ablation is generated (corresponding to the focal point AF described above), to a position, in the resin layer 2, which is located in the vicinity of the interface with the brittle material layer 1 as described above, it is possible to form the scribe groove 11 that is open on the resin layer 2 side, but is prevented from penetrating through the brittle material layer 1.

By adjusting power of the laser beam L1 to be oscillated from the ultrashort pulse laser light source 20, it is possible to adjust the magnitude of energy (the magnitude of intensity within the range from the point A to the point B) used to form the scribe groove 11 (to remove the brittle material). Therefore, it is possible to adjust the depth of the scribe groove 11.

A smaller depth of the scribe groove 11 allows the composite material 10 to have more sufficient bending strength after division. However, an excessively small depth of the scribe groove 11 causes problems in the division of the composite material 10 in the composite material dividing step, which will be described later.

For this reason, the depth of the scribe groove 11 is preferably set to within a range of 3 µm or more and 50 µm or less. The lower limit is more preferably set to 5 µm or more, and is further preferably set to 10 µm or more. The upper limit is more preferably set to 30 µm or less, is still more preferably set to 20 µm or less, is further preferably set to 18 µm or less, and is still further preferably set to 16 µm or less. In the case in which the brittle material layer 1 has a small thickness (in the case in which the thickness is 50 µm or less, for example), the depth of the scribe groove 11 is preferably set to within a range of 3 µm or more and 20 µm or less.

The depth of the scribe groove 11 is preferably set to within a range of 10% or more and 50% or less of the thickness of the brittle material layer 1. The lower limit is more preferably set to 15% or more of the thickness of the brittle material layer 1. The upper limit is more preferably set to 35% or less of the thickness of the brittle material layer 1.

### <Resin removing step>

The resin removing step of the present embodiment is performed after the brittle material removing step.

As shown in Figure 1(b) and Figure 2(b), in the resin removing step, the resin layer 2 is irradiated with a laser beam L2, which is oscillated from a laser light source 30, along the scheduled dividing line DL of the composite material 10 to remove a resin forming the resin layer 2. With such an operation, a processed groove 23 is formed along the scheduled dividing line DL.

For a mode of performing irradiation with the laser beam L2 along the scheduled dividing line DL (a mode of performing scanning with the laser beam L2), a mode can be adopted which is equal to the above-described mode of performing irradiation with the laser beam L1 along the scheduled dividing line DL and hence, the detailed description of such a mode will be omitted in the present embodiment.

In the present embodiment, as the laser light source 30, a CO₂ laser light source is used in which the wavelength of the laser beam L2 to be oscillated is within a range of 9 to 11 µm, which is within the infrared range.

However, the present invention is not limited to the above. As the laser light source 30, it is also possible to use a CO laser light source in which the wavelength of the laser beam L2 to be oscillated is 5 µm.

It is also possible to use a visible or ultraviolet (UV) pulse laser light source as the laser light source 30. Examples of the visible-light and UV pulse laser light source include a light source in which the wavelength of the laser beam L2 to be oscillated is 532 nm, 355 nm, 349 nm, or 266 nm (high-order harmonic of a solid laser light source that uses Nd: YAG, Nd: YLF, or YVO4 as a medium), an excimer laser light source in which the wavelength of the laser beam L2 to be oscillated is 351 nm, 248 nm, 222 nm, 193 nm, or 157 nm, and an F2 laser light source in which the wavelength of the laser beam L2 to be oscillated is 157 nm.

It is also possible to use, as the laser light source 30, a pulse laser light source in which the wavelength of the laser beam L2 to be oscillated falls outside the UV range, and a pulse width is in the order of femtosecond or picosecond. Using the laser beam L2 to be oscillated from this pulse laser light source allows ablation processing that is based on the multiphoton absorption process to be induced.

It is also possible to use, as the laser light source 30, a semiconductor laser light source or a fiber laser light source in which the wavelength of the laser beam L2 to be oscillated is within the infrared range.

As described above, in the present embodiment, a CO₂ laser light source is used as the laser light source 30 and hence, the laser light source 30 is referred to as "CO₂ laser light source 30" hereinafter.

The oscillation mode of the CO₂ laser light source 30 may be either one of pulse oscillation or continuous oscillation. The spatial intensity distribution of the laser beam L2 may be Gaussian distribution, or may be formed into flat-top distribution by using a diffraction optical element (not shown in the drawing) or the like to suppress damage to portions of the brittle material layer 1 that are not the removal object of the laser beam L2. There is no limitation on the polarization state of the laser beam L2, and any one of linear polarization, circular polarization, and random polarization may be adopted.

By irradiating the resin layer 2 (the base film 21 and the pressure-sensitive adhesive layer 22) with the laser beam L2 along the scheduled dividing line DL of the composite material 10, of a resin forming the resin layer 2, a resin that is irradiated with the laser beam L2 (the portions of the base film 21 and the pressure-sensitive adhesive layer 22 that are irradiated with the laser beam L2) has a local temperature rise due to absorption of infrared rays, so that the resin is scattered. Therefore, the resin is removed from the composite material 10, so that the processed groove 23 is formed on the composite material 10. To suppress a situation in which a scattered resin removed from the composite material 10 adheres to the composite material 10 again, it is preferable to provide a dust collection mechanism in the vicinity of the scheduled dividing line DL. To suppress an increase in groove width of the processed groove 23, it is preferable to condense the laser beam L2 in such a way as to have a spot diameter of 300 µm or less at the irradiation position on the resin layer 2, and it is more preferable to condense the laser beam L2 in such a way as to have a spot diameter of 200 µm or less.

Assume a case of a method for removing a resin in which a local temperature rise of a resin that is irradiated with the laser beam L2 is used as the principle, the local temperature rise occurring due to absorption of infrared rays. In such a case, it is possible to roughly estimate input energy necessary to form the processed groove 23 based on the thickness of the resin layer 2 regardless of the kind of resin and the layer structure of the resin layer 2. Specifically, input energy that is necessary to form the processed groove 23 and that is expressed by the following formula (1) can be estimated by the following formula (2) based on the thickness of the resin layer 2. 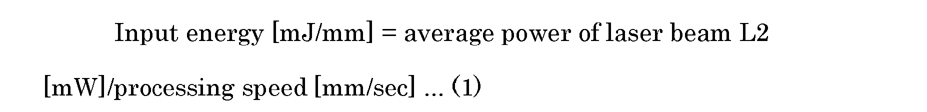 Input energy [mJ/mm] = average power of laser beam L2 [mW]/processing speed [mm/sec] (1) $Imput energy \left[mJ/mm\right] = 0.5 \times thickness of resin layer 2 \left[μm\right]$ (2)

Input energy that is actually set is preferably set to within a range of 20% to 180% of the input energy estimated by the above-mentioned formula (2), and is more preferably set to within a range of 50% to 150% of the input energy estimated by the above-mentioned formula (2). The reason a margin is provided to estimated input energy in this manner is that it is taken into account that a difference is generated in input energy necessary to form the processed groove 23 due to a difference in thermophysical properties, such as light absorption (light absorption at the wavelength of the laser beam L2) of the resin forming the resin layer 2 and the melting point/decomposition point of the resin. Specifically, for example, it is sufficient to determine appropriate input energy by performing a preliminary test in which samples of the composite material 10 to which the division method according to the present embodiment is applied are prepared, and the processed grooves 23 are formed on the resin layers 2 of these samples with a plurality of input energies within the above-mentioned preferred range.

In the resin removing step of the present embodiment, the resin layer 2 is irradiated from the resin layer 2 side with the laser beam L2, which is oscillated from the laser light source 30. In the example shown in Figure 1(a) and Figure 1(b), the CO₂ laser light source 30 is disposed below the composite material 10 in the Z direction in such a way as to face the resin layer 2, and the ultrashort pulse laser light source 20 is disposed above the composite material 10 in the Z direction in such a way as to face the brittle material layer 1. After the scribe groove 11 is formed, in the brittle material removing step, by the laser beam L1 oscillated from the ultrashort pulse laser light source 20, oscillation of the laser beam L1 is stopped, and the processed groove 23 is then formed, in the resin removing step, by the laser beam L2 oscillated from the CO₂ laser light source 30.

However, the present invention is not limited to the above. It is also possible to adopt a method in which both the ultrashort pulse laser light source 20 and the CO₂ laser light source 30 are disposed on the same side with respect to the composite material 10 (above or below the composite material 10 in the Z direction), and the composite material 10 is turned upside down such that the brittle material layer 1 is caused to face the ultrashort pulse laser light source 20 in the brittle material removing step, and the resin layer 2 is caused to face the CO₂ laser light source 30 in the resin removing step.

In the resin removing step, a residue of the resin may be formed at the bottom portion of the formed processed groove 23 as long as no problems occur in the division of the composite material 10 in the composite material dividing step, which will be described later.

However, to surely divide the composite material 10, it is preferable to further include a cleaning step in which a residue of the resin forming the resin layer 2 is removed by cleaning the processed groove 23 which is formed in the resin removing step.

Any of various wet cleaning methods and various dry cleaning methods may be used in the cleaning step. Examples of the wet cleaning method include liquid medicine immersion, ultrasonic cleaning, dry ice blasting, micro-fine-bubble cleaning, and nano-fine-bubble cleaning. For the dry cleaning method, laser, plasma, ultraviolet rays, ozone, or the like may be used.

### <Composite material dividing step>

As shown in Figure 1(c), after the brittle material removing step and the resin removing step are performed, in the composite material dividing step, an external force is applied along the scheduled dividing line DL to divide the composite material 10. In the example shown in Figure 1(c), the composite material 10 is divided into composite material pieces 10a, 10b.

Examples of a method for applying an external force to the composite material 10 include mechanical breaking (folding the composite material 10 in a mountain shape), heating of a region in the vicinity of the scheduled dividing line DL with a laser beam within the infrared range, application of vibrations with an ultrasonic roller, and adhering and lifting by suction cups. In the case in which the composite material 10 is divided by folding the composite material 10 into a mountain shape, it is preferable to apply an external force such that the resin layer 2 side protrudes (the brittle material layer 1 side is recessed) to allow the composite material 10 to be divided by using the resin layer 2 side of the brittle material layer 1 as a starting point, the scribe groove 11 being formed on the resin layer 2 side of the brittle material layer 1.

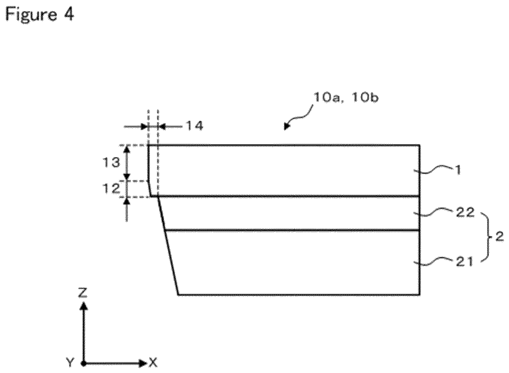

Figure 4 is a cross-sectional view schematically showing the configuration of the composite material piece 10a, 10b obtained after the composite material 10 is divided in the composite material dividing step of the division method according to the present embodiment.

As shown in Figure 4, the composite material piece 10a, 10b is configured such that surface roughness of a first region 12 on one end surface (the end surface on which division is made) of the brittle material layer 1 is greater than surface roughness of a second region 13 on the one end surface, the first region 12 being located on the resin layer 2 side on the one end surface, the second region 13 being located on the side opposite to the resin layer 2 on the one end surface. The first region 12 corresponds to a region in which the scribe groove 11 is formed, and the second region 13 corresponds to a region in which the scribe groove 11 is not formed. Accordingly, the thickness of the first region 12 (the dimension of the first region 12 along the thickness direction of the brittle material layer 1 (Z direction)) is preferably set to within a range of 10% or more and 40% or less of the thickness of the brittle material layer 1. The lower limit is more preferably set to 15% or more of the thickness of the brittle material layer 1. The upper limit is more preferably set to 35% or less of the thickness of the brittle material layer 1.

The one end surface (the end surface on which division is made) of the brittle material layer 1 of the composite material piece 10a, 10b protrudes on the one end surface side (on the left side on the paper surface on which Figure 4 is drawn) compared with the end surface (the end surface on which division is made) of the resin layer 2 on the same side. A protrusion amount 14 of the brittle material layer 1 is, for example, 200 µm or less, is 100 µm or less, or is 50 µm or less, although this changes according to the spot diameter of the laser beam L2 at the irradiation position on the resin layer 2, the laser beam L2 being oscillated from the CO₂ laser light source 30. The lower limit of the protrusion amount 14 is, for example, 1 µm or more, or is 5 µm or more, although a smaller value is more preferable.

According to the division method according to the present embodiment described heretofore, in the brittle material removing step, irradiation is performed with the laser beam L1, which is oscillated from the ultrashort pulse laser light source 20, to remove the brittle material forming the brittle material layer 1, thus forming the scribe groove 11 on the brittle material layer 1. Accordingly, in the composite material dividing step, the composite material 10 is divided by using this scribe groove 11 as a starting point and hence, cracks are less likely to occur on the end surface of the brittle material layer 1 after division.

Further, according to the division method according to the present embodiment, the scribe groove 11 formed in the brittle material removing step is open on the resin layer 2 side, but is prevented from penetrating through the brittle material layer 1. In other words, in the brittle material removing step, a brittle material only on the resin layer 2 side of the brittle material layer 1 is removed to form the scribe groove 11. Accordingly, in the composite material dividing step, the composite material 10 is divided by using this scribe groove 11 as a starting point and hence, it is possible to allow the composite material piece 10a, 10b to have sufficient bending strength after division.

In the present embodiment, the resin removing step is performed after the brittle material removing step. In a configuration not covered by the present invention, the brittle material removing step may be performed after the resin removing step. In other words, the scribe groove 11 is formed after the processed groove 23 is formed.

However, in this case, since, in the brittle material removing step, the focal point AF of the laser beam L1 to be oscillated from the ultrashort pulse laser light source 20 is set to a position, in the resin layer 2, which is located in the vicinity of the interface with the brittle material layer 1, it is necessary for the bottom portion of the processed groove 23 to have a residue of the resin at a point in time of performing the brittle material removing step. Specifically, it is necessary to perform the brittle material removing step in a state in which the thickness of this residue of the resin (that is, the thickness of the resin layer 2 at the irradiation position that is irradiated with the laser beam L1 to be oscillated from the ultrashort pulse laser light source 20) is 5 µm or more.

Hereinafter, the description will be made for one example of the results of tests in which the composite material 10 is divided by the division method according to the present embodiment (examples 1, 2) or a division method according to a comparison example (comparison examples 1, 2).

### <Example 1>

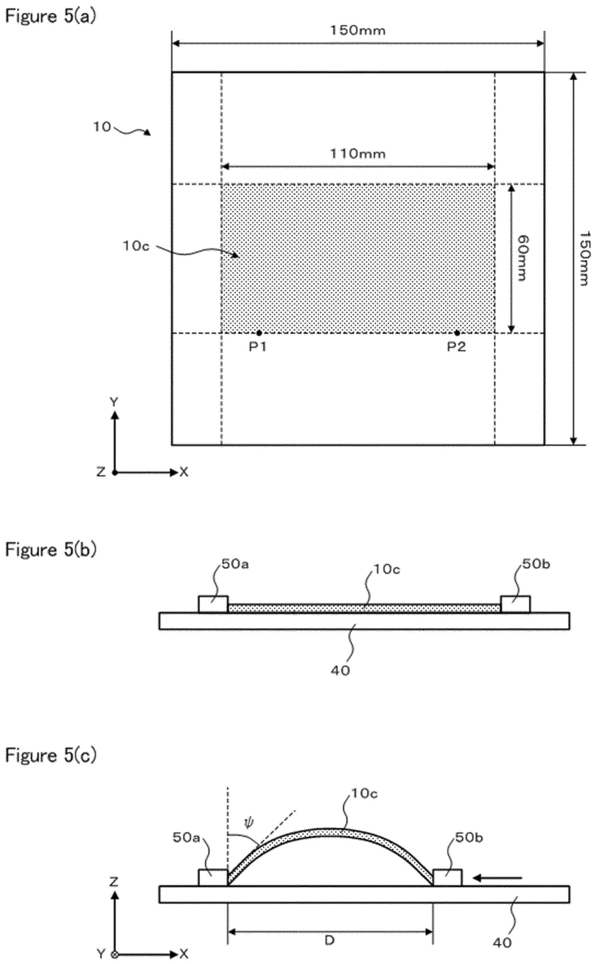

Figures 5(a) to 5(c) are diagrams schematically describing a summary of a test according to an example 1. Hereinafter, the summary of the test according to the example 1 will be described by suitably referring to Figures 1 to 3 and Figure 5.

In a composite material 10 used in the example 1, a brittle material layer 1 is made of alkali-free glass, and has a thickness of 30 µm. A resin layer 2 is a surface protective film, and has a total thickness of 58 µm. Specifically, this surface protective film is a film obtained such that a PET film with a thickness of 38 µm is used as a base film 21, and an acrylic pressure-sensitive adhesive is applied to one surface of the base film 21, and is dried to form a pressure-sensitive adhesive layer (acrylic pressure-sensitive adhesive layer) 22 having a thickness of 20 µm after drying. The composite material 10 is configured such that the brittle material layer 1 and the resin layer 2 are laminated via the pressure-sensitive adhesive layer 22. As shown in Figure 5(a), the composite material 10 has a square shape with in-plane (XY two-dimensional plane) dimensions of 150 mm × 150 mm. Straight lines shown by dashed lines in Figure 5(a) are scheduled dividing lines.

In the example 1, a brittle material removing step was performed first. Next, a resin removing step was performed and, lastly, a composite material dividing step was performed.

In the brittle material removing step, "Monaco 1035-80-60" (oscillation wavelength: 1035 nm, pulse width of laser beam L1: 350 to 10000 femtoseconds, repetition frequency of pulse oscillation: 50 MHz at maximum, average power: 60 W) made by Coherent Corp. was used as an ultrashort pulse laser light source 20, and the composite material 10 was irradiated from the brittle material layer 1 side via a multi-focus optical system with the laser beam L1, which is oscillated from the ultrashort pulse laser light source 20 with a predetermined output. A focal point AF of the laser beam L1 (see Figure 3) was set to the center of the pressure-sensitive adhesive layer 22 of the resin layer 2 in the thickness direction (the position 10 µm distant from the interface with the brittle material layer 1, that is, distance H = 10 µm). Scanning was performed with the laser beam L1 along the scheduled dividing lines with a relative moving speed (processing speed) of the laser beam L1 with respect to the composite material 10 set to 125 mm/sec and with a repetition frequency of pulse oscillation set to 125kHz to obtain, by division, a composite material piece 10c having in-plane dimensions of 110 mm × 60 mm as shown in Figure 5(a). As a result, the scribe grooves 11 each of which is integrally connected along the scheduled dividing line were formed on the brittle material layer 1, the scribe grooves 11 having a depth (average value) of 10 µm and a groove width of approximately 3 µm (see Figure 1(a), Figure 2(a)).

Next, in the resin removing step, "DIAMOND J-3-9.4" (oscillation wavelength: 9.4 µm, repetition frequency of pulse oscillation: 15kHz, power of laser beam L2: 13W, Gaussian beam) made by Coherent Corp. was used as a CO₂ laser light source 30, the laser beam L2 oscillated from the CO₂ laser light source 30 was condensed to have a spot diameter of 120 µm by using a condenser lens, and the resin layer 2 of the composite material 10 was irradiated with the laser beam L2. When scanning was performed with the laser beam L2 along the scheduled dividing lines with a relative moving speed (processing speed) of the laser beam L2 with respect to the composite material 10 set to 400 mm/sec, processed grooves 23 with a groove width of 150 µm (see Figure 1(b), Figure 2(b)) were formed on the resin layer 2.

In the resin removing step in the example 1, input energy estimated by the formula (2) described above is 29 mJ/mm. However, actual input energy is, based on the formula (1) described above, 33 mJ/mm, and is 114% of the estimated input energy.

Lastly, in the composite material dividing step, the composite material 10 was manually folded into a mountain shape along the scheduled dividing lines such that the resin layer 2 side protrudes (the brittle material layer 1 side is recessed). As a result, the composite material piece 10c was obtained by division.

### <Example 2>

In a composite material 10 used in an example 2, a brittle material layer 1 is made of alkali-free glass, and has a thickness of 100 µm. A resin layer 2 is a layer obtained such that an epoxy adhesive agent is applied to one surface of a polarizing film, and is dried to form an adhesive agent layer (an epoxy adhesive agent layer) having a thickness of 1 µm after drying. For a polarizing film, a film was used which is configured such that a TAC film (thickness: 40 µm), a PVA polarizer (thickness: 5 µm), an acrylic film (thickness: 40 µm), an acrylic pressure-sensitive adhesive layer (thickness: 30 µm), and a separator (PET film, thickness: 38 µm) are laminated in this order from the side on which the adhesive agent layer is formed. The composite material 10 is configured such that the brittle material layer 1 and the resin layer 2 are laminated via the adhesive agent layer. In the same manner as the example 1, the composite material 10 used in the example 2 also has a square shape with in-plane (XY two-dimensional plane) dimensions of 150 mm × 150 mm.

In the example 2, scribe grooves 11 were formed under conditions substantially equal to the conditions in the example 1 except for that, in a brittle material removing step, a focal point AF of a laser beam L1 was set to the center of the adhesive agent layer of the resin layer 2 in the thickness direction (the position 0.5 µm distant from the interface with the brittle material layer 1, that is, distance H = 0.5 µm). A resin removing step and a composite material dividing step are also performed under conditions equal to the conditions in the example 1 to obtain a composite material piece 10c by division.

### <Comparison example 1>

In a composite material 10 used in a comparison example 1, a brittle material layer 1 is made of alkali-free glass and has a thickness of 30 µm in the same manner as the example 1. A resin layer 2 is a layer obtained such that an epoxy adhesive agent is applied to one surface of a TAC film (thickness: 40 µm), and is dried to form an adhesive agent layer (an epoxy adhesive agent layer) having a thickness of 1 µm after drying. The composite material 10 is configured such that the brittle material layer 1 and the resin layer 2 are laminated via the adhesive agent layer. In the same manner as the examples 1, 2, the composite material 10 used in the comparison example 1 also has a square shape with in-plane (XY two-dimensional plane) dimensions of 150 mm × 150 mm.

In the comparison example 1, a resin removing step was performed first. Next, a brittle material removing step was performed and, lastly, a composite material dividing step was performed.

In the resin removing step, "DIAMOND J-3-9.4" (oscillation wavelength: 9.4 µm, repetition frequency of pulse oscillation: 15kHz, power of laser beam L2: 18W, Gaussian beam) made by Coherent Corp. was used as a CO₂ laser light source 30, the laser beam L2 oscillated from the CO₂ laser light source 30 was condensed to have a spot diameter of 120 µm by using a condenser lens, and the resin layer 2 of the composite material 10 was irradiated with the laser beam L2. When scanning was performed with the laser beam L2 along scheduled dividing lines with a relative moving speed (processing speed) of the laser beam L2 with respect to the composite material 10 set to 400 mm/sec, processed grooves 23 with a groove width of 150 µm were formed on the resin layer 2. A residue of the resin was not formed at the bottom portion of the processed groove 23.

In the resin removing step in the comparison example 1, input energy estimated by the formula (2) described above is 21 mJ/mm. However, actual input energy is, based on the formula (1) described above, 45 mJ/mm, and is 214% of the estimated input energy.

Next, in the brittle material removing step, a laser light source having an oscillation wavelength of 1035 nm, the pulse width of a laser beam L1 of 8500 femtoseconds, a repetition frequency of pulse oscillation of 125kHz, and average power of 13W was used as an ultrashort pulse laser light source 20, and the composite material 10 was irradiated from a side opposite to the processed groove 23 (the brittle material layer 1 side) via a multi-focus optical system with the laser beam L1, which is oscillated from the ultrashort pulse laser light source 20 with a predetermined output. A focal point AF of the laser beam L1 was set to a position 25 µm distant from the interface between the brittle material layer 1 and the resin layer 2 toward the brittle material layer 1. When scanning was performed with the laser beam L1 along the scheduled dividing line, with a relative moving speed (processing speed) of the laser beam L1 with respect to the composite material 10 set to 125 mm/sec, perforated through holes (diameter: approximately 0.7 to 0.9 µm) were formed, at a pitch of 1 µm, on the brittle material layer 1 as a processed mark.

Lastly, in the same manner as the examples 1, 2, in the composite material dividing step, the composite material 10 was manually folded into a mountain shape along the scheduled dividing lines such that the resin layer 2 side protrudes (the brittle material layer 1 side is recessed). As a result, a composite material piece 10c was obtained by division.

### <Comparison example 2>

The configuration of a composite material 10 used in a comparison example 2 is equal to the configuration in the example 2.

Conditions of a resin removing step, a brittle material removing step, and a composite material dividing step performed in the comparison example 2 are equal to the corresponding conditions in the comparison example 1.

### <Details of evaluation>

The composite material pieces 10c obtained in the examples 1, 2 and the comparison examples 1, 2 described above were evaluated for absorbance, bending strength, and division yield rate. Hereinafter, the details of respective evaluation items will be described.

### [Absorbance]

For the example 1, absorbance of the resin layer 2 (total thickness: 58 µm) at an oscillation wavelength of 1035 nm of the ultrashort pulse laser light source 20 was measured. For each of the example 2 and the comparison examples 1, 2, absorbance of the adhesive agent layer (thickness: 1 µm) of the resin layer 2 at an oscillation wavelength of 1035 nm of the ultrashort pulse laser light source 20 was measured.

Specifically, the above-mentioned measurement region (the resin layer 2 for the example 1, the adhesive agent layer for each of the example 2 and the comparison examples 1, 2) was extracted from the composite material piece 10c, and was irradiated with a beam with a wavelength of 1035 nm by using a spectrophotometer "U-4100" made by Hitachi, Ltd., and transmittance (I/I0) was then measured. Absorbance A was calculated by the following formula (3). $A = - {log}_{10} \left(I/I0\right)$ (3)

### [Bending strength]

In calculating bending strength, a two-point bending test was executed on the composite material piece 10c. In the two-point bending test, first, as shown in Figure 5(b), the composite material piece 10c was placed on a fixing part 40 of a one-axis stage including the fixing part 40 and movable parts 50a, 50b, and the composite material piece 10c was sandwiched between the movable parts 50a, 50b. At this point of operation, the composite material piece 10c was placed on the fixing part 40 such that, as will be described later, when the movable part 50b is moved, the composite material piece 10c bends with the brittle material layer side of the composite material piece 10c protruding (that is, with the brittle material layer 1 side forming the upper side). Next, as shown in Figure 5(c), the movable part 50b was moved toward the movable part 50a at a speed of 20 mm/min with the movable part 50a fixed to apply bending stress to the composite material piece 10c. The bending strength of the composite material piece 10c was evaluated based on the value of a distance D between the movable part 50a and the movable part 50b at the time of breakage of the composite material piece 10c.

Specifically, the maximum stress σₘₐₓ was calculated by substituting the above-mentioned distance D into the formula (3) (same as the following formula (4)) described in Non Patent Literature 2, and was taken as bending strength.
[Formula 1] ${σ}_{max} = 1.198 \left(\frac{Et}{D - t}\right) {\left(cosψ\right)}^{1 / 2}$ (4)

In the above-mentioned formula (4), "E" denotes the Young's modulus of the composite material piece 10c, "t" denotes the thickness of the composite material piece 10c, and "ψ" denotes an angle formed by a tangent to the end of the composite material piece 10c and the vertical direction (Z direction).

For the Young's modulus E of the composite material piece 10c, 70GPa, which is the Young's modulus of the brittle material layer 1, was used. The reason is as follows. The Young's modulus of the resin layer 2 is sufficiently lower than the Young's modulus of the brittle material layer 1 and hence, the Young's modulus of the brittle material layer 1 dominates as the Young's modulus E of the composite material piece 10c.

The angle ψ was calculated as follows. During the execution of the two-point bending test, the composite material piece 10c was photographed from the Y direction shown in Figure 5(c) such that one end of the composite material piece 10c is located in the field of view, and the angle ψ was calculated based on an image photographed immediately before the composite material piece 10c is broken.

For each of the examples 1, 2 and the comparison examples 1, 2, the above-mentioned bending strengths (maximum stresses σₘₐₓ) of ten composite material pieces 10c were calculated, and the average value was calculated.

### [Division yield rate]

Quality of the end surface of the composite material piece 10c was observed by an optical microscope. When formed cracks have a length of 50 µm or less on all of four end surfaces of the brittle material layer 1, evaluation "dividable" was given. When cracks with a length of more than 50 µm are formed on any one of the end surfaces, evaluation "undividable" was given. For each of the examples 1, 2 and the comparison examples 1, 2, the above-mentioned evaluation was performed on ten composite material pieces 10c, and a division yield rate was calculated by the following formula (5). $\begin{matrix}Division yield rate = the number of " dividable " composite material \\ pieces 10 c / 10 \times 100 \\ = the number of " dividable " composite material pieces 10 c \times \\ 10 \left[%\right]\end{matrix}$ (5)

### <Test result>

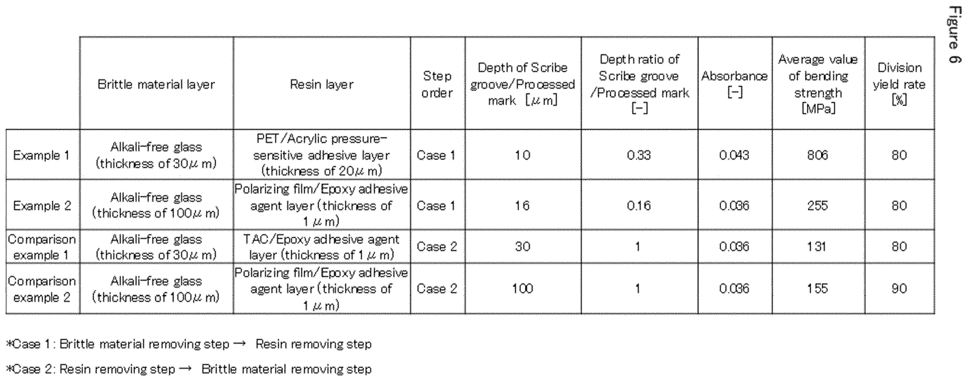

Figure 6 is a diagram showing the results of the tests according to the examples 1, 2 and the comparison examples 1, 2.

As shown in Figure 6, it was found that the example 1, 2 can maintain the division yield rate at a value substantially equal to the corresponding value of the comparison example 1, 2 (that is, cracks are less likely to occur on the end surfaces of the brittle material layer 1 after division in the same manner as the comparison example 1, 2), and can also increase bending strength of the composite material piece 10c after division compared with the comparison example 1, 2.

### [Reference Signs List]

- 1: brittle material layer
- 2: resin layer
- 10: composite material
- 11: scribe groove
- 20: ultrashort pulse laser light source
- 30: laser light source (CO₂ laser light source)
- 23: processed groove
- AF: focal point
- DL: scheduled dividing line
- L1: laser beam
- L2: laser beam

## Claims

1. A method for dividing a composite material in which a brittle material layer and a resin layer are laminated, the method comprising:
a brittle material removing step in which irradiation is performed from a brittle material layer (1) side with a laser beam (L1, L2), which is oscillated from an ultrashort pulse laser light source, along a scheduled dividing line of the composite material to remove a brittle material forming the brittle material layer, thus forming a scribe groove (11) integrally connected along the scheduled dividing line; and
a resin removing step in which the resin layer (2) is irradiated with a laser beam, which is oscillated from a laser light source (30), along the scheduled dividing line to remove a resin forming the resin layer, wherein
the resin removing step is performed after the brittle material removing step,
a pulse width of the laser beam to be oscillated from the ultrashort pulse laser light source is within a range of 350 femtoseconds or more and 10000 femtoseconds or less,
the method being **characterized by**:
in the brittle material removing step, the laser beam is oscillated from the ultrashort pulse laser light source to form the scribe groove that is open on a resin layer side, but is prevented from penetrating through the brittle material layer, the laser beam being oscillated in a state in which a focal point of the laser beam to be oscillated from the ultrashort pulse laser light source is set to a position, in the resin layer, which is located in a vicinity of an interface with the brittle material layer, and a thickness of the resin layer at an irradiation position that is irradiated with the laser beam to be oscillated from the ultrashort pulse laser light source is 5 µm or more.

2. The method according to claim 1, further comprising a composite material dividing step in which the composite material is divided by applying an external force along the scheduled dividing line (DL), the composite material dividing step being performed after the brittle material removing step and the resin removing step are performed.

3. The method according to claim 1 or 2. wherein a depth of the scribe groove is within a range of 3 µm or more and 50 µm or less.

4. The method according to claim 3, wherein the depth of the scribe groove is 20 µm or less.

5. The method according to claim 1 or 2. wherein a depth of the scribe groove is within a range of 10% or more and 50% or less of a thickness of the brittle material layer.

6. The method according to any one of claims 1 to 5, wherein a wavelength of the laser beam to be oscillated from the ultrashort pulse laser light source is within a range of 500 nm or more and 2500 nm or less.

## Patentansprüche

1. Verfahren zum Teilen von Verbundmaterial, in welchem eine Sprödmaterialschicht und eine Harzschicht laminiert sind, wobei das Verfahren umfasst:
einen Schritt zum Entfernen des Sprödmaterials, bei welchem von einer Sprödmaterialschicht-(1)-Seite mit einem Laserstrahl (L1, L2), der von einer Ultrakurzpulslaser-Lichtquelle oszilliert wird, eine Bestrahlung entlang einer vorgesehenen Teilungslinie des Verbundmaterials durchgeführt wird, um ein die Sprödmaterialschicht bildendes Sprödmaterial zu entfernen, wodurch eine entlang der vorgesehenen Teilungslinie durchgehend verbundene Ritznut (11) gebildet wird; und
einen Schritt zum Entfernen des Harzes, bei welchem die Harzschicht (2) mit einem Laserstrahl, der von einer Laserlichtquelle (30) oszilliert wird, entlang der vorgesehenen Teilungslinie bestrahlt wird, um ein die Harzschicht bildendes Harz zu entfernen, wobei
der Schritt zum Entfernen des Harzes nach dem Schritt zum Entfernen des Sprödmaterials durchgeführt wird,
eine Pulsbreite des Laserstrahls, der von der Ultrakurzpulslaser-Lichtquelle oszilliert wird, innerhalb eines Bereichs von 350 Femtosekunden oder mehr und 10.000 Femtosekunden oder weniger liegt, wobei das Verfahren **dadurch gekennzeichnet ist, dass**:
der Laserstrahl im Schritt zum Entfernen des Sprödmaterials von der Ultrakurzpulslaser-Lichtquelle oszilliert wird, um die Ritznut zu bilden, die auf einer Harzschichtseite offen ist, aber daran gehindert wird, die Sprödmaterialschicht zu durchdringen, wobei der Laserstrahl in einem Zustand oszilliert wird, in welchem ein Fokuspunkt des Laserstrahls, der von der Ultrakurzpulslaser-Lichtquelle oszilliert werden soll, auf eine Position in der Harzschicht gesetzt ist, die in einer Nähe einer Schnittfläche mit der Sprödmaterialschicht angeordnet ist, und eine Dicke der Harzschicht an einer Bestrahlungsposition, die mit dem Laserstrahl bestrahlt wird, der von der Ultrakurzpulslaser-Lichtquelle oszilliert werden soll, 5 µm oder mehr beträgt.

2. Verfahren nach Anspruch 1, weiter umfassend einen Schritt zum Teilen des Verbundmaterials, bei welchem das Verbundmaterial durch Aufbringen einer äußeren Kraft entlang der vorgesehenen Teilungslinie (DL) geteilt wird, wobei der Schritt zum Teilen des Verbundmaterials durchgeführt wird, nachdem der Schritt zum Entfernen des Sprödmaterials und der Schritt zum Entfernen des Harzes durchgeführt worden sind.

3. Verfahren nach Anspruch 1 oder 2, wobei eine Tiefe der Ritznut innerhalb eines Bereichs von 3 µm oder mehr und 50 µm oder weniger liegt.

4. Verfahren nach Anspruch 3, wobei die Tiefe der Ritznut 20 µm oder weniger beträgt.

5. Verfahren nach Anspruch 1 oder 2, wobei eine Tiefe der Ritznut innerhalb eines Bereichs von 10 % oder mehr und 50 % oder weniger einer Dicke der Sprödmaterialschicht liegt.

6. Verfahren nach einem der Ansprüche 1 bis 5, wobei eine Wellenlänge des Laserstrahls, der von der Ultrakurzpulslaser-Lichtquelle oszilliert werden soll, innerhalb eines Bereichs von 500 nm oder mehr und 2500 nm oder weniger liegt.

## Revendications

1. Procédé de division d'un matériau composite dans lequel une couche de matériau fragile et une couche de résine sont stratifiées, le procédé comprenant :
une étape de retrait de matériau fragile dans laquelle une irradiation est effectuée à partir d'un côté de couche (1) de matériau fragile avec un faisceau (L1, L2) laser, qui est mis en oscillation par une source de lumière laser pulsée ultracourte, le long d'une ligne de division prévue du matériau composite pour retirer un matériau fragile formant la couche de matériau fragile, formant ainsi une rainure (11) d'incision reliée d'un seul tenant le long de la ligne de division prévue ; et
une étape de retrait de résine dans laquelle la couche (2) de résine est irradiée avec un faisceau laser, qui est mis en oscillation par une source de lumière (30) laser, le long de la ligne de division prévue pour retirer une résine formant la couche de résine, dans lequel
l'étape de retrait de résine est effectuée après l'étape de retrait de matériau fragile,
une largeur d'impulsion du faisceau laser devant être mis en oscillation par la source de lumière laser pulsée ultracourte se trouve dans une plage de 350 fs ou plus et 10 000 fs ou moins, le procédé étant **caractérisé par le fait que** :
dans l'étape de retrait de matériau fragile, le faisceau laser est mis en oscillation par la source de lumière laser pulsée ultracourte pour former la rainure d'incision qui est ouverte sur un côté de couche de résine, mais est empêché de pénétrer à travers la couche de matériau fragile, le faisceau laser étant mis en oscillation dans un état dans lequel un point focal du faisceau laser devant être mis en oscillation par la source de lumière laser pulsée ultracourte est réglé sur une position, dans la couche de résine, qui est située au voisinage d'une interface avec la couche de matériau fragile, et une épaisseur de la couche de résine au niveau d'une position d'irradiation qui est irradiée avec le faisceau laser devant être mis en oscillation par la source de lumière laser pulsée ultracourte est 5 µm ou plus.

2. Procédé selon la revendication 1, comprenant en outre une étape de division de matériau composite dans laquelle le matériau composite est divisé par application d'une force externe le long de la ligne de division prévue (DL), l'étape de division de matériau composite étant effectuée après que l'étape de retrait de matériau fragile et l'étape de retrait de résine sont effectuées.

3. Procédé selon la revendication 1 ou la revendication 2 dans lequel une profondeur de la rainure d'incision se trouve dans une plage de 3 µm ou plus et 50 µm ou moins.

4. Procédé selon la revendication 3, dans lequel la profondeur de la rainure d'incision est 20 µm ou moins.

5. Procédé selon la revendication 1 ou la revendication 2 dans lequel une profondeur de la rainure d'incision se trouve dans une plage de 10 % ou plus et 50 % ou moins d'une épaisseur de la couche de matériau fragile.

6. Procédé selon l'une quelconque des revendications 1 à 5, dans lequel une longueur d'onde du faisceau laser devant être mis en oscillation par la source de lumière laser pulsée ultracourte se trouve dans une plage de 500 nm ou plus et 2 500 nm ou moins.
